# EUROPEAN PATENT APPLICATION

(11) **EP 2 386 607 A2**
(43) Date of publication of application: **16.11.2011**
(21) Application number: 09832081.5
(22) Date of filing: 07.12.2009
(51) Int. Cl.: C09B 59/00

(54) **NOVEL ORGANIC DYE CONTAINING TRIALKOXYSILYL GROUP AND METHOD FOR PREPARING SAME**

(30) Priority: 09.12.2008 KR 20080124833
(71) Applicant: Dongjin Semichem Co., Ltd., Seo-gu Incheon 404-205 (KR); Korea University Industrial & Academic Collaboration Foundation, Seoul 136-701 (KR)
(72) Inventor: LEE, Chong-chan, Chungcheongbuk-Do 363-883 (KR); KO, Jae-jung, Chungcheongbuk-Do 361-736 (KR); KIM, Jeum-jong, Sacheon-si Gyeongsangnam-do 664-801 (KR)
(74) Representative: Bockhorni & Kollegen
(86) International application number: PCT/KR2009/007267
(87) International publication number: WO 2010/067996

(57) **Abstract**

Disclosed is a novel organic dye containing trialkoxysilyl group and a method of preparing the same. The dye compound of the present invention has higher photovoltaic cell performance and more excellent stability than the existing dyes, and thus may be used for a dye-sensitized solar cell (DSSC) to largely improve solar cell efficiency.

## Description

### BACKGROUND OF THE INVENTION

### (a) Field of the Invention

This disclosure relates to a novel organic dye containing a trialkoxysilyl group in an anchoring group, which has high photovoltaic cell performance and excellent stability and is used for a dye-sensitized solar cell (DSSC), and a method of preparing the same.

### (b) Description of the Related Art

Since a dye-sensitized nanoparticle titanium oxide solar cell was developed by Michael Gratzel et al., of EPFL (Ecole Polytechnique F d rale de Lausanne) at 1991, many studies thereon has been progressed. A dye-sensitized solar cell may replace the existing amorphous silicon solar cell because it has high efficiency and remarkably low manufacture cost compared to the existing silicon type solar cell, and unlike the silicon solar cell, it is a photoelectrochemical solar cell consisting of a dye molecule capable of absorbing visible light to generate electron-hole pairs and transition metal oxide transferring the produced electrons.

As the dye for the dye-sensitized solar cell, a ruthenium metal complex exhibiting high photoelectric conversion efficiency of 10% or more has been widely used, but the ruthenium metal complex is too expensive and difficult to purify.

Recently, it was found that a metal-free organic dye exhibiting excellent properties of absorption efficiency, redox reaction stability and charge-transfer (CT) absorption can be used as a dye for a solar cell replacing the expensive ruthenium metal complex, and thus, studies on metal-free organic dyes are concentrated.

An organic dye generally has an electron donor - an electron acceptor residues connected by π -bond unit. In most organic dyes, an amine derivative function as an electron donor, 2-cyanoacrylic acid or rhodanine residue functions as an electron acceptor, and the two parts are connected by π -bond system such as a metaphosphorous unit or a thiophene chain.

In general, structural change of the electron donor amine unit may result in change in electron properties, for example blue shifted absorption spectrum, and change π -bond length, thus controlling absorption spectrum and redox potential.

However, most of so far known organic dyes have rapid and narrow absorption band in blue area of visible light to cause decrease in photo-collecting performance, and have comparatively low thermal stability and photo-stability. Therefore, there have been continued attempts to develop an organic dye with high photoelectric conversion efficiency and excellent long-term stability.

### SUMMARY OF THE INVENTION

It is an object of the present invention to provide an organic dye that has high photovoltaic cell performance and excellent stability and thus may largely improve solar cell efficiency by replacing a 2-cyanoacrylic acid or rhodanine residue conventionally functioning as an electron acceptor, and a method of preparing the same.

It is another object of the present invention to provide a dye-sensitized photoelectric conversion device comprising the above described dye and exhibiting remarkably improved photoelectric conversion efficiency, and excellent Jsc (short circuit photocurrent density) and molar extinction coefficient, and a solar cell having remarkably improved efficiency.

The present invention provides a dye containing a trialkoxysilyl group represented by the following Chemical Formula 1:

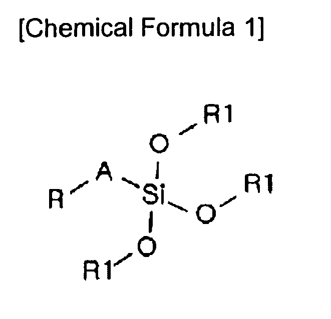

Wherein,
R is a C₁₋₅₀ alkyl, aryl, alkoxy or heteroaryl group unsubstituted or substituted by a C₁₋₅₀ alkyl, alkoxy, halogen, amide, cyano, hydroxyl, nitro, acyl, aryl or heteroaryl group,
A is a divalent organic group containing a C₁₋₅₀ aryl or heteroaryl group unsubstituted or substituted by halogen, amide, cyano, hydroxyl, nitro, acyl, C₁₋₃₀ alkyl, C₁₋₃₀ alkoxy, C₁₋₃₀ alkylcarbonyl or C₆₋₂₀ aryl group,
R₁ is independently a C₁₋₅₀ alkyl group unsubstituted or substituted by a C₁₋₃₀ alkyl, alkoxy, halogen, amide, cyano, hydroxyl, nitro, acyl, aryl or heteroaryl group.

The present invention also provides a method of preparing a trialkoxysilyl group containing dye represented by the Chemical Formula 1, comprising
(1) reacting a compound of the following Chemical Formula 2 with I₂ in an organic solvent to prepare a compound of the following Chemical Formula 3, (2) reacting the compound of the Chemical Formula 3 with a compound of the following Chemical Formula 4:

   R-A [Chemical Formula 2]

   R-A-I [Chemical Formula 3]

   SiH(OR₁)₃ [Chemical Formula 4]

   In the Chemical Formulas 2 to 4, R, A, R₁ are as defined above.

The present invention also provides a dye-sensitized photoelectric conversion device comprising oxide semiconductor particles on which the trialkoxysilyl group containing dye represented by the Chemical Formula 1 is supported.

The present invention also provides a dye-sensitized solar cell comprising the above dye-sensitized photoelectric conversion device as an electrode.

The novel trialkoxysilyl group containing dye of the present invention may exhibit improved photovoltaic cell performance, i.e., high molar extinction coefficient, Jsc (short circuit photocurrent density) and photoelectric conversion efficiency, and excellent stability, and thus largely improve solar cell efficiency, by replacing a 2-cyanoacrylic acid or rhodanine residue which have conventionally functioned as an electron receptor.

### BRIEF DESCRIPTION OF THE DRAWINGS

Fig. 1 shows adsorption and emission spectrums of the dyes of the Chemical Formula 1-1 and Chemical Formula 1-2 prepared in Examples 1 and 2, respectively measured in tetrahydrofuran (THF).
Fig. 2 shows a photovoltaic cell performance (monochromatic incident photon-to current conversion efficiency (IPCEs) spectrum) and photocurrent density - voltage (J-V) curves of DSSC prepared using the dyes of the Chemical Formula 1-1 and Chemical Formula 1-2 (dashed line: Chemical Formula 1-1, solid line: Chemical Formula 1-2).
Fig. 3 shows measurement results of (a) electron emission coefficient and (b) lifetime of DSSC using the dyes of the Chemical Formula 1-1 and Chemical Formula 1-2 (for comparison, a dye-sensitized solar cell comprising the conventional dye of N719 was also manufactured).

### DETAILED DESCRIPTION OF THE EMBODIMENTS

The inventors found that if a novel dye compound containing a trialkoxysilyl group in an anchoring group is supported on oxide semiconductor particles to prepare a dye-sensitized solar cell, the solar cell has high photoelectric conversion efficiency, Jsc (short circuit photocurrent density) and molar extinction efficiency and excellent stability thus exhibiting high solar cell efficiency, and completed the invention.

The organic dye of the present invention is represented by the following Chemical Formula 1.

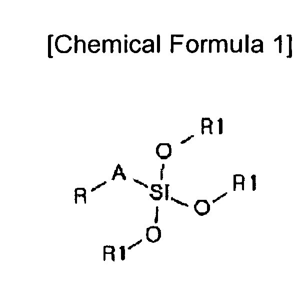

Wherein,
R is a C₁₋₅₀ alkyl, aryl, alkoxy or heteroaryl group unsubstituted or substituted by a C₁₋₅₀ alkyl, alkoxy, halogen, amide, cyano, hydroxyl, nitro, acyl, aryl or heteroaryl group,
A is a divalent organic group containing a C₁₋₅₀ aryl or heteroaryl group unsubstituted or substituted by halogen, amide, cyano, hydroxyl, nitro, acyl, C₁₋₃₀ alkyl, C₁₋₃₀ alkoxy, C₁₋₃₀ alkylcarbonyl or C₆₋₂₀ aryl group, and
R₁ is independently a C₁₋₅₀ alkyl group unsubstituted or substituted by a C₁₋₃₀ alkyl, alkoxy, halogen, amide, cyano, hydroxyl, nitro, acyl, aryl or heteroaryl group.

Preferably, A is selected from the group consisting of the following A-1 to A-4.

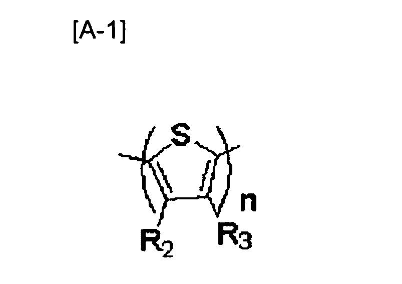

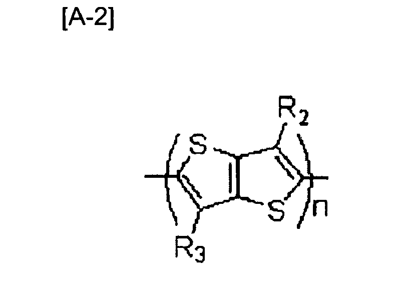

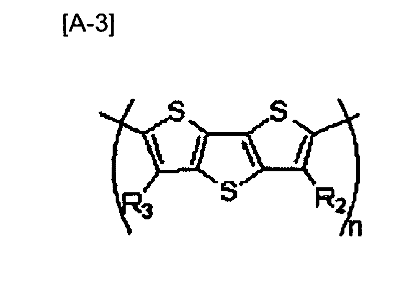

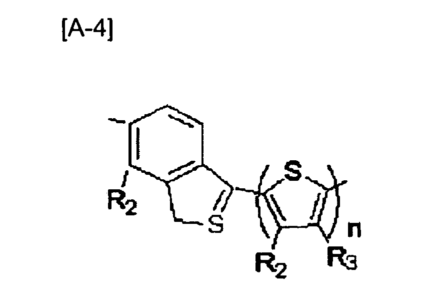

In the A-1 to A-4, R₂ and R₃ are independently hydrogen, halogen, amide, cyano, hydroxyl, nitro, acyl, C₁₋₃₀ alkyl, C₁₋₃₀ alkoxy, or C₁₋₃₀ alkylcarbonyl, and n is an integer of from 1 to 5.

Preferably, R is selected from the group consisting of the following R-1 to R-9: 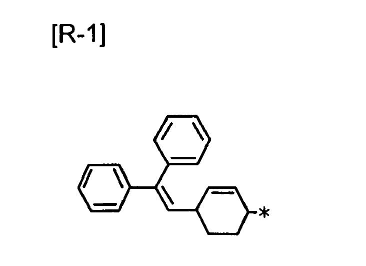 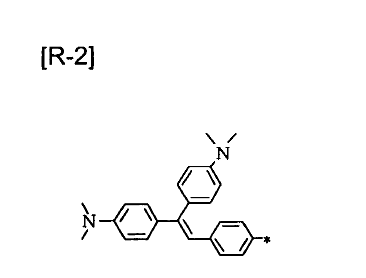 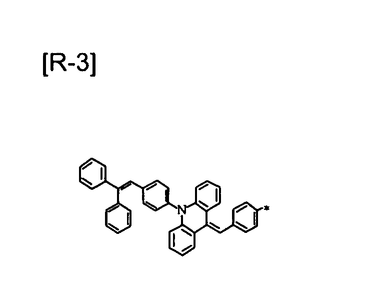 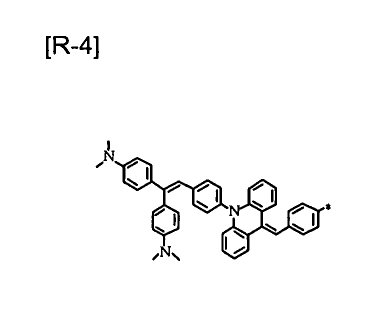 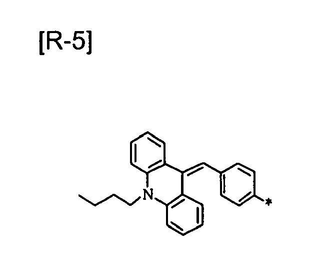 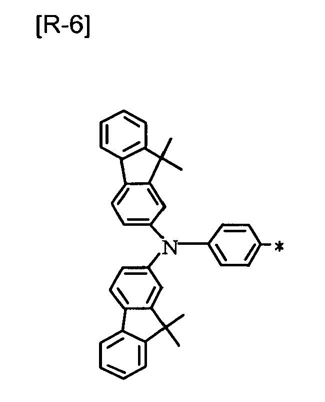 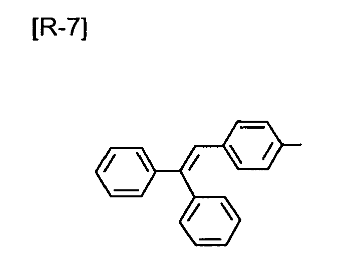 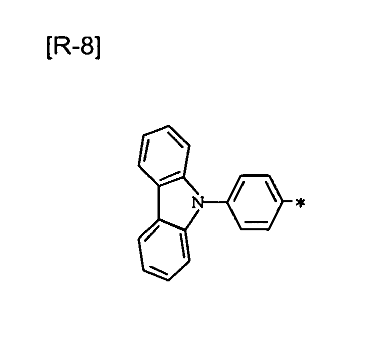 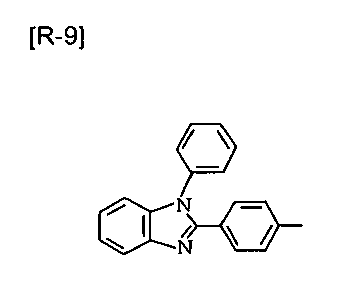 (* or - part is a bond)

More preferably, the compound of the Chemical Formula 1 is represented by the following Chemical Formula 1-1 or Chemical Formula 1-2:

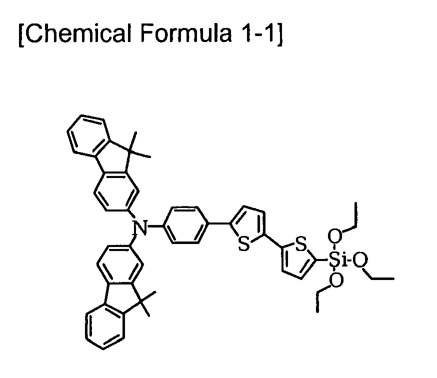

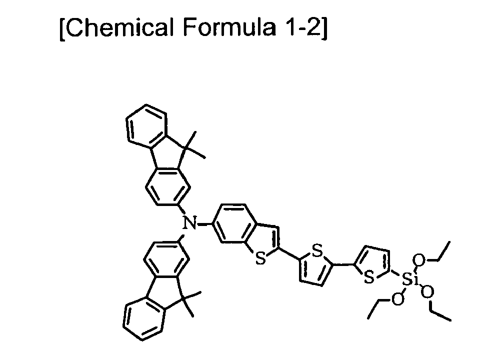

The present invention also provides a method of preparing a dye represented by the Chemical Formula 1, which comprises (1) reacting a compound of the following Chemical Formula 2 with I₂ in an organic solvent to prepare a compound of the following Chemical Formula 3, (2) reacting the compound of the Chemical Formula 3 with a compound of the following Chemical Formula 4:

R-A [Chemical Formula 2]

R-A-I [Chemical Formula 3]

SiH(OR₁)₃ [Chemical Formula 4]

In the Chemical Formulas 2 to 4, R, A, R₁ are as defined in the Chemical Formula 1.

Specifically, the dyes of the Chemical Formula 1-1 and 1-2 may be prepared by the following Reaction Equation.

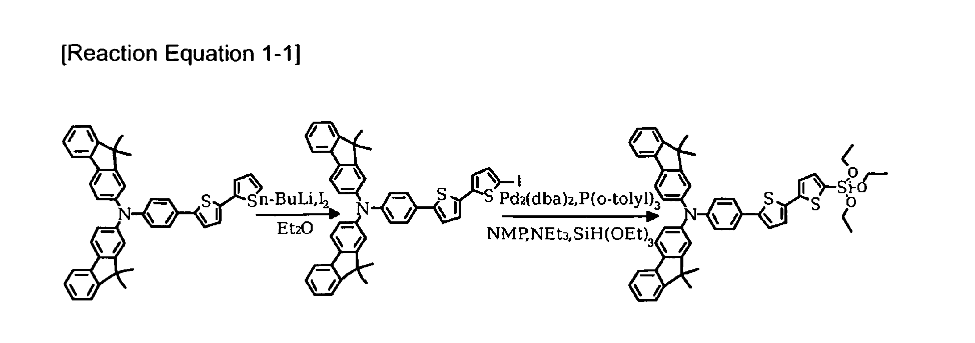

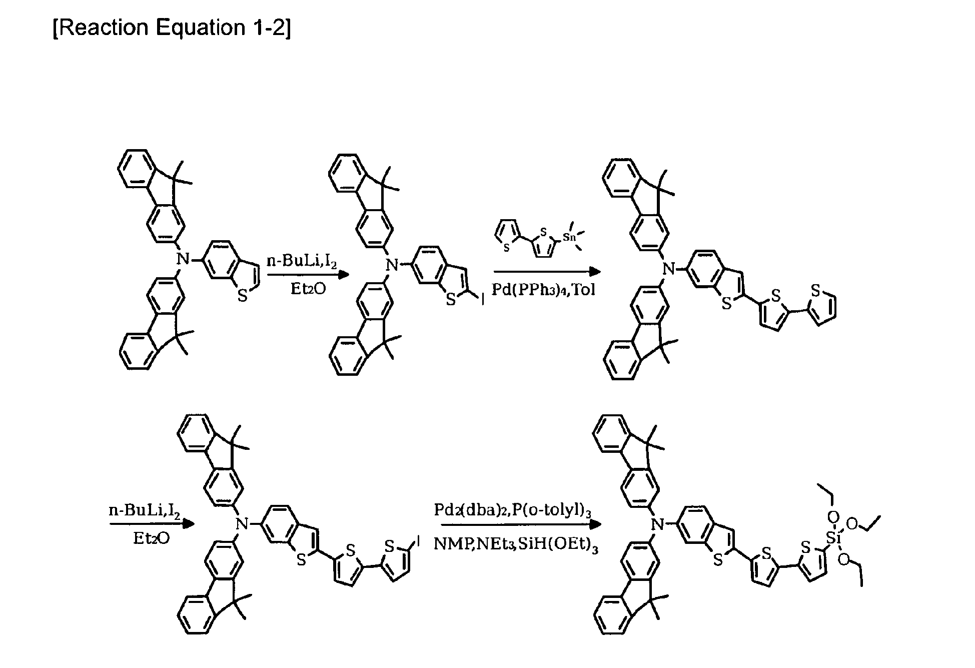

In the Reaction Equations 1-1 and 1-2, the compound used as starting material may be prepared by a common method.

The present invention also provides a dye-sensitized photoelectric conversion device comprising oxide semiconductor particles on which the trialkoxysilyl group containing dye of the Chemical Formula 1 is supported. The dye-sensitized photoelectric conversion device of the present invention may be manufactured by a conventional method of manufacturing a dye-sensitized photoelectric conversion device for solar cell, except using the dye of the Chemical Formula 1, and preferably, it may be manufactured by forming an oxide semiconductor thin film on a substrate using oxide semiconductor particles, and then, supporting the dye of the present invention on the thin film.

As the substrate on which the oxide semiconductor thin film is formed, those having a conductive surface are preferable, and those commercially available may be used. Specific examples thereof may include those obtained by forming a thin film of metals such as steel, silver, gold, etc. or conductive metal oxide such as indium, fluorine, antimony tin oxide on the surface of transparent polymer material such as polyethyleneterephthalate or polyethersulfone, etc. The conductivity may be preferably 1000 Ω or less, particularly 100 Ω or less.

As the oxide semiconductor particle, metal oxide is preferable. Specific examples thereof may include oxides of titanium, tin, zinc, tungsten, zirconium, gallium, indium, yttrium, niobe, tantalum, vanadium, etc. Zinc oxide and tin oxide are more preferable, and titanium oxide is most preferable. The oxide semiconductor may be used alone or in combination, or it may be coated on the surface of semiconductor.

The average diameter of the oxide semiconductor particle may be preferably 1 - 500 nm, more preferably 1 - 100 nm. And, the oxide semiconductor particles with large particle diameter and those with small particle diameter may be mixed, or they may be multilayeredly used.

The oxide semiconductor thin film may be directly formed on a substrate for example by spraying oxide semiconductor particles, or it may be formed by a method of electrically precipitating a semiconductor particle thin film with a substrate as an electrode, or by a method of coating a paste containing particles obtainable by hydrolysis of semiconductor particle precursor such as semiconductor alkoxide or semiconductor particle slurry on a substrate, and then, drying, curing or firing. And, the method of coating a paste on a substrate is preferable. In this method, the slurry may be obtained by dispersing secondarily coagulated oxide semiconductor particles in a dispersion medium by a common method such that the average primary particle diameter may become 1 - 200 nm.

The dispersion medium for dispersing the slurry may include those capable of dispersing semiconductor particles without specific limitation, and specific examples thereof may include water, alcohol such as ethanol, etc., ketone such as acetone, acetylacetone, etc., hydrocarbon such as hexane, etc. and a combination thereof. Water is preferable because it minimizes viscosity change of the slurry. And, a dispersion stabilizer may be used to stabilize the dispersion state of the oxide semiconductor particle. Specific examples of the dispersion stabilizer may include acid such as acetic acid, hydrochloric acid, nitric acid, etc., acetylacetone, acrylic acid, polyethyleneglycol, polyvinylacohol, etc.

The substrate coated with the slurry may be fired, the firing temperature may be 100 °C or more, preferably 200 °C or more, and the upper limit may be generally a melting point of the substrate, commonly 900 °C, preferably 600 °C. The firing time may be preferably within 4 hours, but is not specifically limited thereto.

The thickness of the thin film on the substrate may be 1 - 200 µm, preferably 1 - 50 µm. The firing may cause a partial deposition of the thin layer of oxide semiconductor particles, which does not specifically affect the present invention.

Further, the oxide semiconductor thin film may be secondarily treated. For example, the thin film may be immersed in a solution of alkoxide, chloride, nitride, sulfide, etc. of the same metal as the semiconductor, and drying or refiring, thereby improving the performance of the semiconductor thin film. The metal alkoxide may include titanium ethoxide, titanium isopropoxide, titanum t-butoxide, n-dibutyl-diacetyl ti, etc., and the alcohol thereof may be used. The chloride may include titanium tetrachloride, tin tetrachloride, zinc chloride, etc., and the aqueous solution thereof may be used. The obtained oxide semiconductor thin film consists of oxide semiconductor particles.

A method of supporting dye on the oxide semiconductor particle thin film is not specifically limited, and for example, a substrate on which the oxide semiconductor thin film is formed may be immersed in a dispersion obtained by dispersing the dye of the Chemical Formula 1 or a solution obtained by dissolving the dye in a solvent capable of dissolving it. The concentration of the dye in the solution or dispersion may be appropriately determined. The immersion temperature may be room temperature to a boiling point of the solvent, and the immersion time may be 1 minute to 48 hours. The solvent for dissolving the dye may include methanol, ethanol, acetonitrile, dimethylsulfoxide, dimethyiformamide, acetone, t-butanol, etc. The concentration of dye may be commonly 1 × 10⁻⁶ M ^{∼} 1 M, preferably 1 × 10⁻⁵ M ^{∼} 1 × 10⁻¹ M. Thereby, a photoelectric conversion device having a dye-sensitized oxide semiconductor particle thin film may be obtained.

One kind of the dye of the Chemical Formula 1 may be supported, or several kinds of dyes may be mixed and supported. If dyes are mixed, the dye of the present invention may be mixed with other dyes or metal complex dyes. The metal complex dyes that can be mixed with the dye of the present invention may include a ruthenium complex or a quaternary salt thereof, phthalocyanine, porphyrin, etc., but not limited thereto. The organic dye that can be mixed may include metal-free phthalocyanine, porphyrin or cyanine, merocyanine, oxonol, triphenylmethane dyes, methyne dyes such as acrylate dyes suggested in WO2002/011213, xanthene dyes, azo dyes, antraquinone dyes, perylene dyes, etc (See [M.K.Nazeeruddin, A.Kay, I.Rodicio, R.Humphry-Baker, E.Muller, P.Liska, N.Vlachopoulos, M.Gratzel, J. Am. Chem. Soc., vol 115, p6382(1993)]). If two or more kinds of dyes are used, the dyes may be sequentially adsorbed on a semiconductor thin film, or they may be mixed and dissolved and then, adsorbed.

Further, when the dye is supported on the oxide semiconductor thin film, the dye may be preferably supported in the presence of an inclusion compound in order to prevent bonding between dyes. The inclusion compound may include cholic acid such as deoxycholic acid, dehydrodeoxycholic acid, kenodeoxycholic acid, cholic acid methyl ester, sodium cholic acid, etc. a steroid compound such as polyethyleneoxide, cholic acid, etc., crownether, cyclodextrin, calixaren, polyethyleneoxide, etc.

After the dye is supported, the semiconductor electrode surface may be treated with an amine compound such as 4-t-butyl pyridine, etc., or a compound having an acid group such as acetic acid, propionic acid, etc. The treatment may be conducted for example by immersing a substrate on which a dye-supported semiconductor particle thin film is formed in an ethanol solution of amine.

The present invention also provides a dye-sensitized solar cell comprising the above dye-sensitized photoelectric conversion device, which may be manufactured by a conventional method of preparing a solar cell except using the dye-sensitized photoelectric conversion device using the dye-supported oxide semiconductor particle. For example, it may consist of a photoelectric conversion device electrode (negative electrode) wherein the dye of the Chemical Formula 1 is supported on the oxide semiconductor particle, a counter electrode (positive electrode), redox electrolyte, hole-transporting material or p-type semiconductor, etc.

Preferably, the dye-sensitized solar cell of the present invention may be manufactured by coating a titanium oxide paste on a conductive transparent substrate, firing the paste-coated substrate to form a titanium oxide thin film, impregnating the substrate having the titanium oxide thin film with a mixed solution in which the dye represented by the Chemical Formula 1 is dissolved so as to form a dye-adsorbed titanium oxide film electrode, providing a second glass substrate on which a counter electrode is formed, forming a hole penetrating the second glass substrate and the counter electrode, positioning a thermoplastic polymer film between the counter electrode and the dye-adsorbed titanium oxide film electrode and conducting a hot pressing process so as to bond the counter electrode and the titanium oxide film electrode, injecting electrolyte into the thermoplastic polymer film between the counter electrode and the titanium oxide film electrode through the hole, and sealing the thermoplastic polymer.

The redox electrolyte, hole-transporting material, p-type semiconductor may be liquid, a solidified type (gel and gel phase), solid, etc. The liquid type may include those obtained respectively dissolving the redox electrolyte, dissolved salts, hole-transporting material, p-type semiconductor, etc. in a solvent, or room temperature dissolved salts, and the solidified type (gel and gel phase) may include those including the redox electrolyte, dissolved salts, hole-transporting material, p-type semiconductor in a polymer matrix or a low molecular weight gelling agent, etc. The solid type may include redox electrolyte, dissolved salts, hole-transporting material, p-type semiconductor, etc.

The hole-transporting material may include amine derivatives, conductive polymer such as polyacetylene, polyaniline, polythiophene, etc., and those using discotic liquid crystal such as triphenylene compounds, etc. The p-type semiconductor may include Cul, CuSCN, etc. As the counter electrode, those having conductivity and catalyzing reduction of the redox electrolyte may be preferable. For example, those obtained by depositing platinum, carbon, rhodium, ruthenium, etc. on a glass or polymer film, or coating conductive particles may be used.

The redox electrolyte may include halogen redox electrolyte consisting of a halogen compound with a halogen ion as a counter ion and a halogen molecule, metal redox electrolyte such as metal complex such as ferrocyanate salt-ferrocyanate salt or ferrocene-ferricinium ion, cobalt complex, etc., organic redox electrolyte such as alkylthiol-alkyidisulfide, viologen dyes, hydroquinone-quinone, etc., and the halogen redox electrolyte is preferable. In the halogen redox electrolyte consisting of a halogen compound and a halogen molecule, the halogen molecule may be preferably an iodine molecule, and the halogen compound with a halogen ion as a counter ion may include metal halide such as Lil, Nal, Kl, Cal2, Mgl2, Cul, etc., an organic ammonium salt of halogen such as tetraalkylammonium iodide, imidazolium iodide, pyridium iodide, etc., and I₂.

If the redox electrolyte is composed in the form of a solution comprising the same, as the solvent, an electrochemically inert solvent may be used. Specific examples thereof may include acetonitrile, propylenecarbonate, ethylenecarbonate, 3-methoxypropionitrile, methoxyacetonitrile, ethyleneglycol, propyleneglycol, dietyleneglycol, triethyleneglycol, butyrolactone, dimethoxyethane, dimethylcarbonate, 1,3-dioxolan, methylformate, 2-methyltetrahydrofuran, 3-methoxy-oxazolidin-2-on, sulfolane, tetrahydrofuran, water, etc., and acetonitrile, propyelencarbonate, ethylenecarbonate, 3-methoxypropionitrile, ethyleneglycol, 3-methoxy-oxazolidin-2-on, butyrolactone, etc. are particularly preferred. The solvent may be used alone or in combination. As the gel phase positive electrolyte, those including electrolyte or an electrolyte solution in a matrix such as oligomer and polymer, or those including electrolyte or an electrolyte solution in starch gelling agent, etc. may be used. The concentration of the redox electrolyte may be preferably 0.1 - 99 wt%, more preferably 0.1 - 30 wt%.

The solar cell of the present invention may be manufactured by positioning a photoelectric conversion device (negative electrode) wherein dyes are supported on oxide semiconductor particles on a substrate, and a counter electrode (positive electrode) so as to be opposite thereto; and filling a solution containing redox electrolyte therebetween.

Hereinafter, the present invention will be illustrated by the following Examples, but the scope of the invention is not limited thereto.

### [Example]

### [Example 1] Synthesis of compound 1-1

A compound 1-1 was prepared as described in the Reaction Equation 1-1.

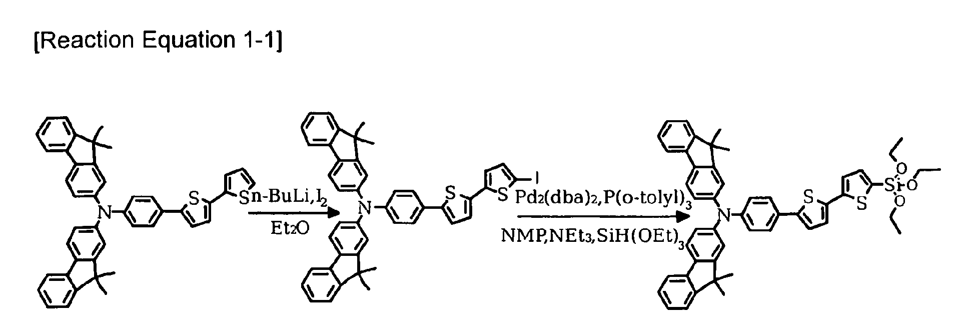

### [Example 2] Synthesis of compound 1-2

A compound 1-2 was prepared as described in the Reaction Equation 1-2.

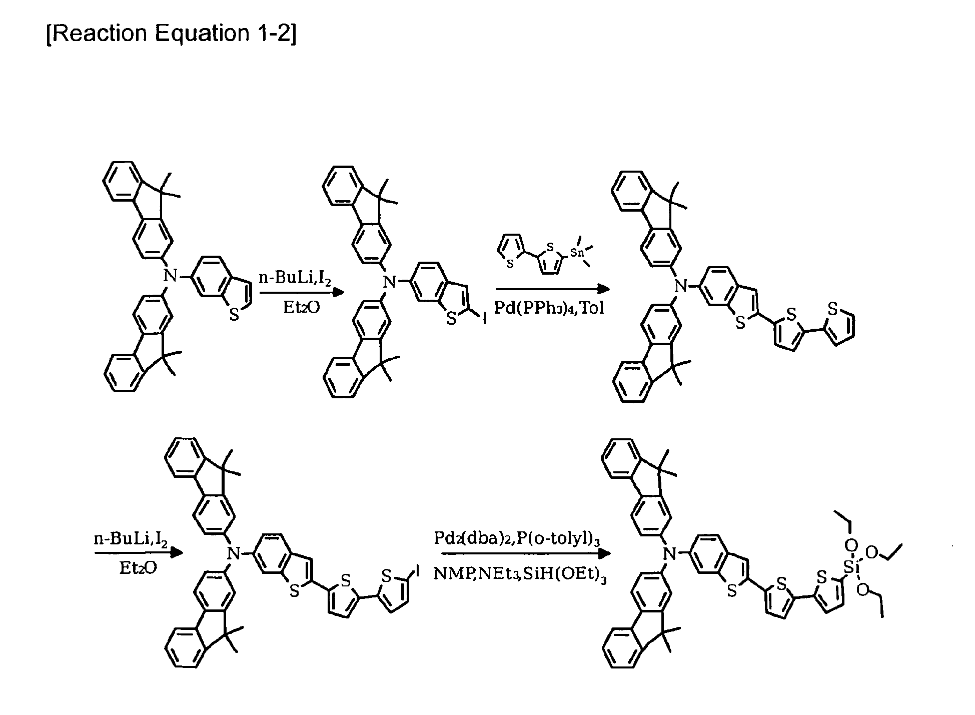

### [Example 3] Manufacture of a dye-sensitized solar cell

To evaluate current-voltage properties of the dye compound according to the present invention, a solar cell was manufactured with a 10+4 µm TiO₂ dual layer. A TiO₂ paste (Solaronix, Ti-Nanoxide T/SP) was screen printed on a fluorine-doped tin oxide glass substrate to form a first TiO₂ transparent layer with a thickness of 10 µm, and for light scattering, a second TiO₂ scattering layer with a thickness of 4 µm was formed with another paste (CCIC, PST-400C). The TiO₂ electrode was treated with a 40 mM TiCl₄ solution at 70 °C for 30 minutes, and sintered at 500 °C for 30 minutes. Subsequently, the TiO₂ electrode was respectively impregnated with the dye compound 1-1 solution and the compound 1-2 solution (0.3 mM dye in tetrahydrofuran) of the present invention prepared in Example 1 and 2, and then, allowed to stand at room temperature for 24 hours. A hot melt film (Surlyn) was positioned as a spacer between the dye-adsorbed TiO₂ electrode and a platinum counter electrode, and heated to 80 °C to assemble a sealed sandwich type electrode. As an electrolyte solution, 1,2-dimethyl-n-propylimidazolium iodide (DMPIml) (0.6M), I₂ (0.1M), NMBI (0.5M) and poly(vinylidenefluoride-co-hexafluoro)propylene (PVDF-HFP) (5 wt%) dissolved in 3-methoxypropionitrile (MPN) were used.

### [Experimental Example] Measurement of properties of the dyes prepared in Examples and a dye-sensitized solar cell comprising the same

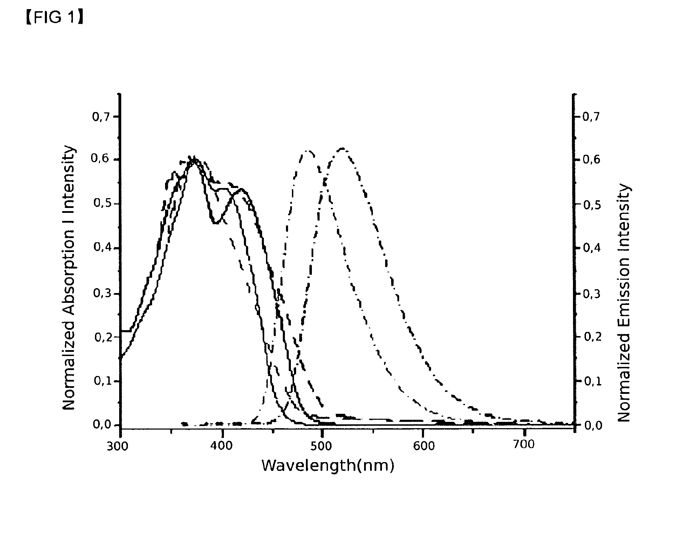

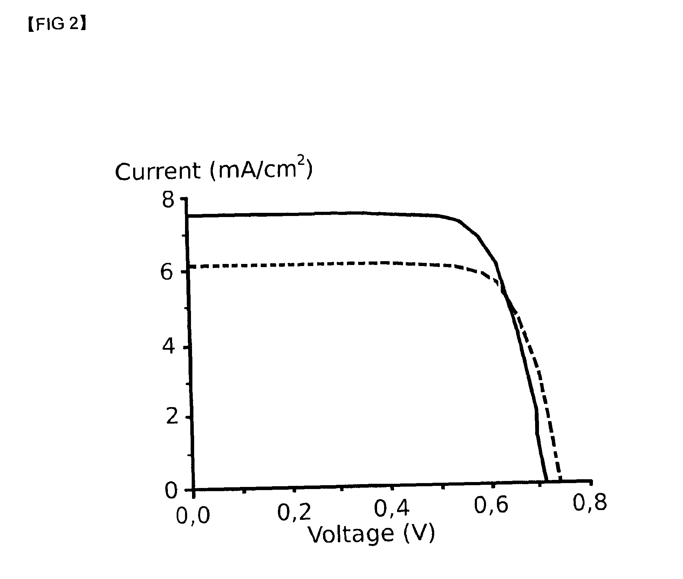

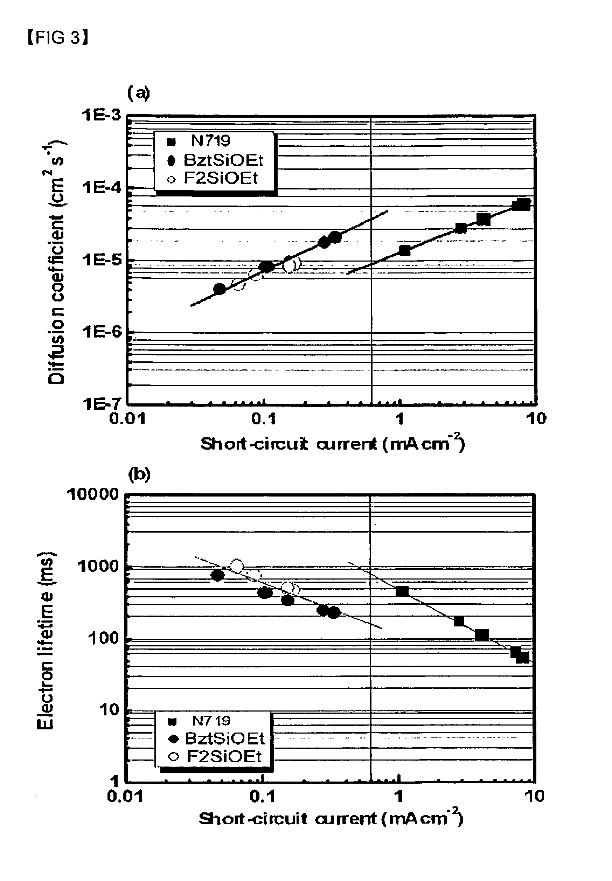

The properties of the organic dyes prepared in Example 1 and 2 were measured and shown in Fig. 1, and the properties of dye-sensitized solar cells comprising the organic dyes were measured and shown in Figs. 2 and 3. The results are summarized in the following Table 1.

**[Table 1]**

| Dye | _{abs}^{a}/nm (ε /M⁻¹cm⁻¹) | *E*ₒₓ,^{b}(Δ Eₚ) / V *vs* NHE | *E*₀₋₀,^{c} / V *vs* NHE | *E*_{LUMO},^{d}/ V *vs* NHE | J_{SC} (mAcm⁻² ) | V_{OC} (V) | FF | η (%) |
|---|---|---|---|---|---|---|---|---|
| Chemical Formula 1-1 | 374(60 000); 402(53 600) | 1.59(0.17) | 2.77 | -1.18 | 6.18 | 0.73 | 0.75 | 3.42 |
| Chemical Formula 1-2 | 373(62 800); 419(56 300) | 1.54(0.27) | 2.63 | -1.09 | 7.52 | 0.71 | 0.75 | 4.01 |
| - a: absorption spectrum measured in THF solution | | | | | | | | |
| - b: oxidation potential of TiO₂-supported dye compared to NHE (common hydrogen | | | | | | | | |
| electrode), measured in CH₃CN together with 0.1 M (*n*-C₄H₉)₄NPF₆ | | | | | | | | |
| (scan speed of 50 mVs⁻¹) | | | | | | | | |
| - c: cross point of absorption spectrum and emission spectrum in THF | | | | | | | | |
| - d: a value calculated by Eox - *E*₀₋₀. DSSC performance for an operation area of 100 | | | | | | | | |
| mW/cm² | | | | | | | | |

Absorption and emission spectrums of the dyes of the Chemical Formulas 1-1 and 1-2 prepared in Examples 1 and 2, measured in tetrahydrofuran (THF) are shown in Fig. 1 (Gray: Chemical Formula 1-1, Black: Chemical Formula 1-2). The absorption spectrum of the Chemical Formula 1-1 shows two maximum absorption peaks at 374 nm and 402 nm for the Chemical Formula 1-1, and the absorption spectrum of the Chemical Formula 1-2 shows maximum absorption peaks at 373 nm and 419 nm. As shown, the dye of the Chemical Formula 1-2 could shift light absorption band to a longer wavelength compared to the dye of the Chemical Formula 1-1.

Photovoltaic cell performance (monochromatic incident photon-to-current conversion efficiency (IPCEs) spectrum) and photocurrent-density-voltage (J-V) curvesof the dyes of the Chemical Formulas 1-1 and 1-2 are shown in Fig. 2 (dashed line: Chemical Formula 1-1, solid line: Chemical Formula 1-2).

And, electron emission coefficient (a) and lifetime (b) of DSSC manufactured by supporting the dyes of the Chemical Formula 1-1 and 1-2 (for comparison, a dye-sensitized solar cell comprising conventional dye of N719 was also manufactured and compared) were measured and shown in Fig. 3 (white circle: Chemical Formula 1-1, black circle: Chemical Formula 1-2).

As shown in Figs. 1 to 3 and Table 1, the novel dye of the present invention exhibits excellent molar extinction coefficient, Jsc (short circuit photocurrent density), photoelectric conversion efficiency and stability and thus can be useful as the dye of a dye-sensitized solar cell.

The novel dye containing a trialkoxysilyl group of the present invention exhibits improved photovoltaic cell performance, i.e., high molar extinction coefficient, Jsc (short circuit photocurrent density) and photoelectric conversion efficiency, and excellent stability, thus largely improving solar cell efficiency, by replacing a 2-cyanoacrylic acid or rhodanine residue which conventionally functions as an electron receptor.

## Claims

1. A dye containing a trialkoxysilyl group represented by the following Chemical Formula 1: 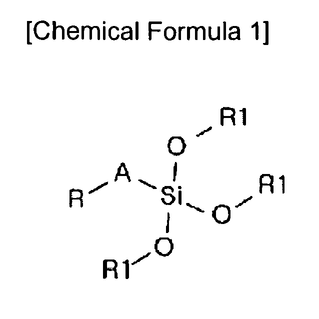 Wherein,
R is a C₁₋₅₀ alkyl, aryl, alkoxy or heteroaryl group unsubstituted or substituted by a C₁₋₅₀ alkyl, alkoxy, halogen, amide, cyano, hydroxyl, nitro, acyl, aryl or heteroaryl group,
A is a divalent organic group containing a C₁₋₅₀ aryl or heteroaryl group unsubstituted or substituted by halogen, amide, cyano, hydroxyl, nitro, acyl, C₁₋₃₀ alkyl, C₁₋₃₀ alkoxy, C₁₋₃₀ alkylcarbonyl or C₆₋₂₀ aryl group, and
R₁ is independently a 6₁-₅₀ alkyl group unsubstituted or substituted by a C₁₋₃₀ alkyl, alkoxy, halogen, amide, cyano, hydroxyl, nitro, acyl, aryl or heteroaryl group.

2. The dye according to claim 1, wherein A is selected from the group consisting of the following A-1 to A-4: 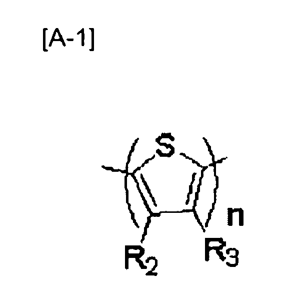 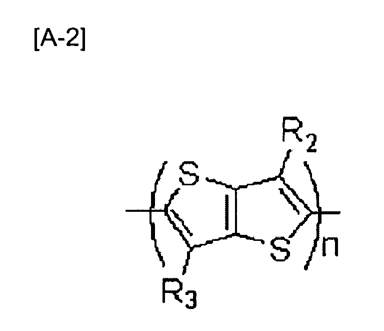 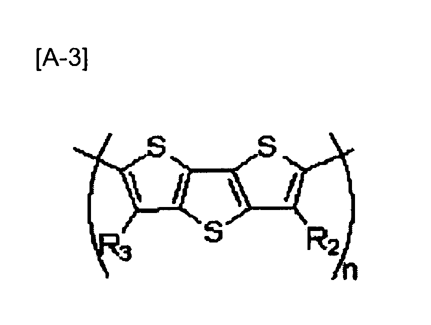 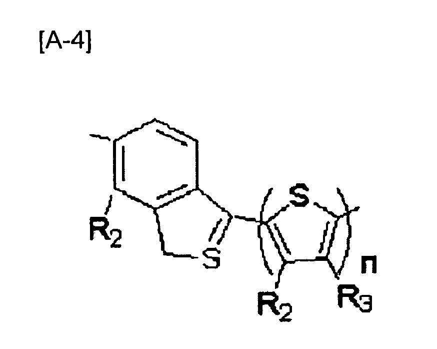 In the A-1 to A-4, R₂ and R₃ are independently hydrogen, halogen, amide, cyano, hydroxyl, nitro, acyl, C₁₋₃₀ alkyl, C₁₋₃₀ alkoxy, or C₁₋₃₀ alkylcarbonyl, and n is an integer of from 1 to 5.

3. The dye according to claim 1, wherein R is selected from the group consisting of the following R-1 to R-9: 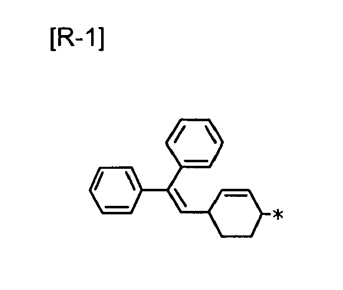 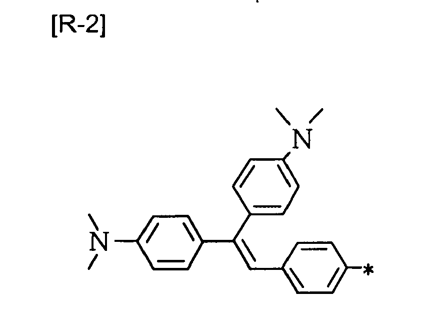 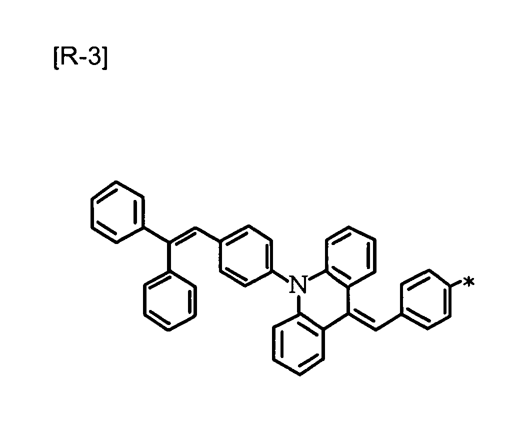 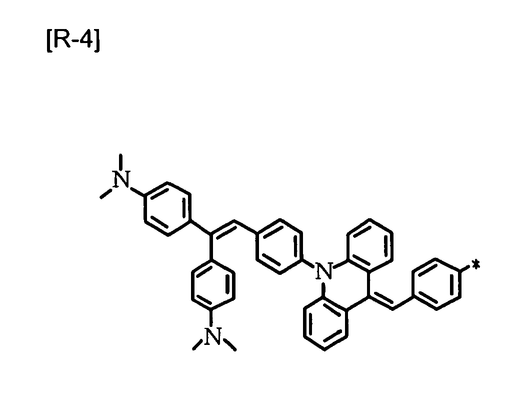 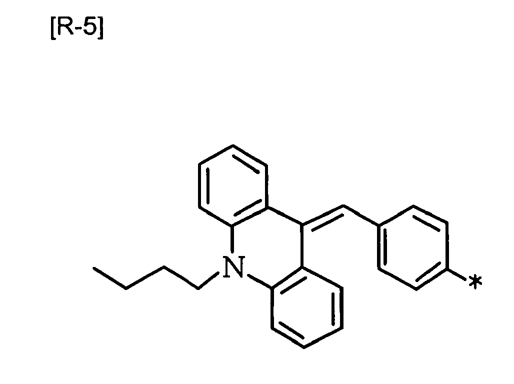 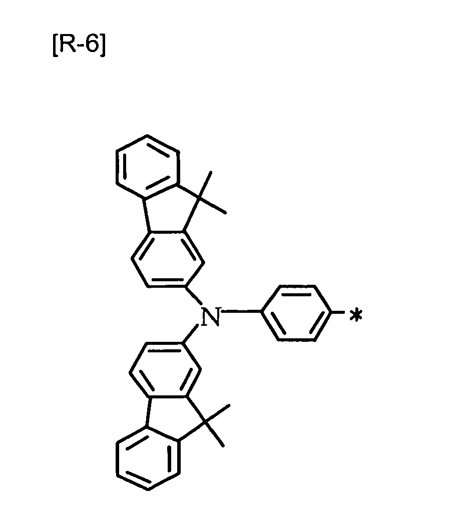 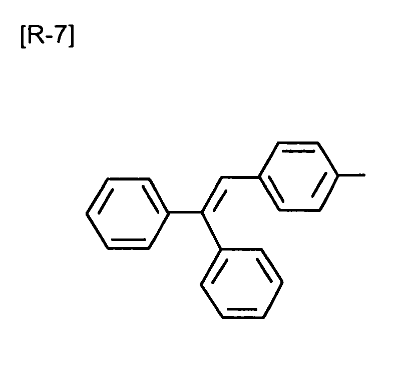 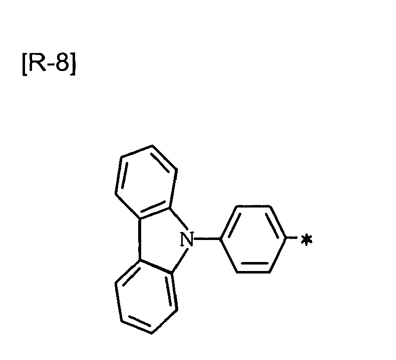 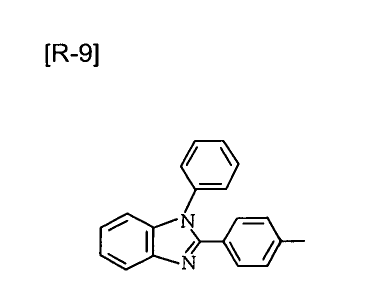 (* or - part is a bond)

4. The dye according to claim 1, wherein the dye is represented by the following Chemical Formula 1-1 or Chemical Formula 1-2:

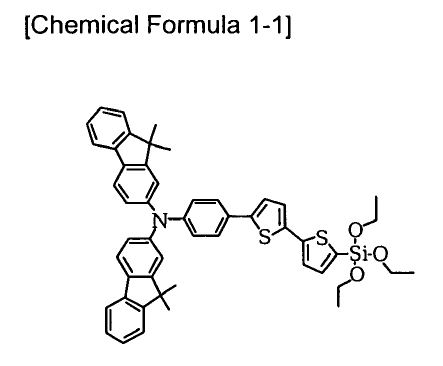

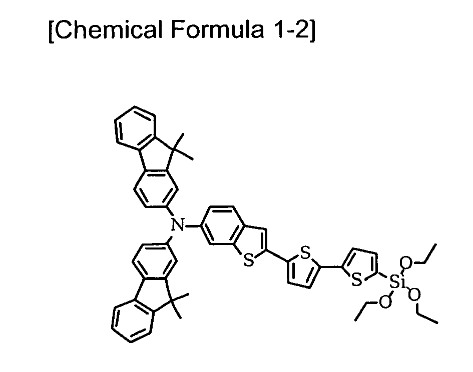

5. A method of preparing a trialkoxysilyl group containing dye represented by the Chemical Formula 1, comprising
(1) reacting a compound of the following Chemical Formula 2 with I₂ in an organic solvent to prepare a compound of the following Chemical Formula 3, (2) reacting the compound of the Chemical Formula 3 with a compound of the following Chemical Formula 4:
R-A [Chemical Formula 2]
R-A-I [Chemical Formula 3]
SiH(OR₁)₃ [Chemical Formula 4]
In the Chemical Formulas 2 to 4, R, A, R₁ are as defined in the Chemical Formula 1 of claim 1.

6. The method of claim 5, wherein the method follows the Reaction Equation 1-1 or 1-2:

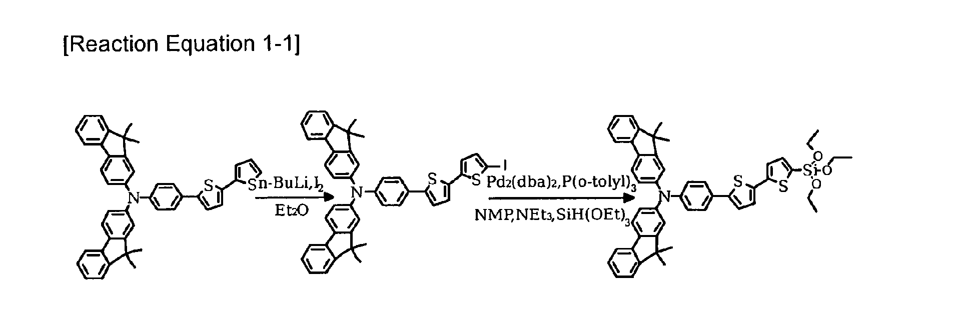

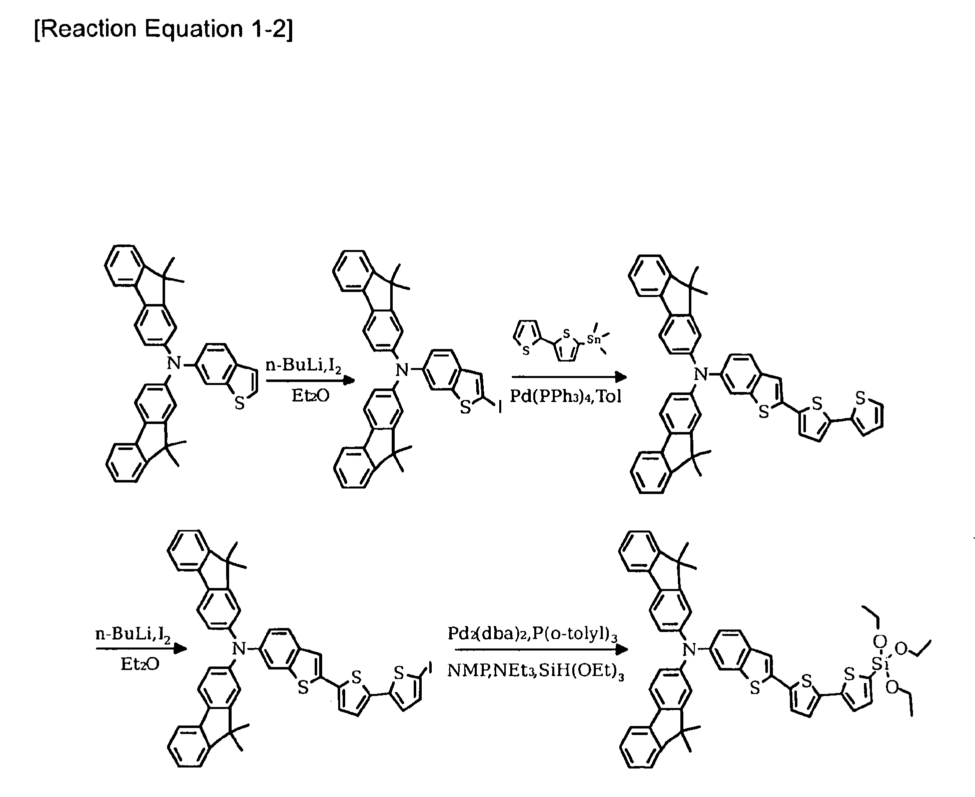

7. A dye-sensitized photoelectric conversion device comprising oxide semiconductor particles on which the trialkoxysilyl group containing dye of claim 1 is supported.

8. A dye-sensitized solar cell comprising the dye-sensitized photoelectric conversion device of claim 7 as an electrode.

9. The dye-sensitized solar cell of claim 8, wherein the dye-sensitized solar cell is manufactured by
coating a titanium oxide paste on a conductive transparent substrate, firing the paste-coated substrate to form a titanium oxide thin film, impregnating the substrate having the titanium oxide thin film with a mixed solution in which the dye represented by the Chemical Formula 1 is dissolved so as to form a dye-adsorbed titanium oxide film electrode, providing a second glass substrate on which a counter electrode is formed, forming a hole penetrating the second glass substrate and the counter electrode, positioning a thermoplastic polymer film between the counter electrode and the dye-adsorbed titanium oxide film electrode and conducting a hot pressing process so as to bond the counter electrode and the titanium oxide film electrode, injecting electrolyte into the thermoplastic polymer film between the counter electrode and the titanium oxide film electrode through the hole, and sealing the thermoplastic polymer.
